# EUROPEAN PATENT APPLICATION

(11) **EP 4 787 422 A1**
(43) Date of publication of application: **05.08.2026**
(21) Application number: 24872423.9
(22) Date of filing: 26.09.2024
(51) Int. Cl.: H01L 21/02, B26F 3/00

(54) **SUBSTRATE SEPARATION DEVICE**

(30) Priority: 29.09.2023 JP 2023170829
(71) Applicant: Shibaura Mechatronics Corporation, Yokohama-shi, Kanagawa 247-8610 (JP)
(72) Inventor: MOCHIZUKI Yosuke, Yokohama-shi, Kanagawa 247-8610 (JP); MUTO Makoto, Yokohama-shi, Kanagawa 247-8610 (JP); OWARI Shunta, Yokohama-shi, Kanagawa 247-8610 (JP)
(74) Representative: Hoffmann Eitle
(86) International application number: PCT/JP2024/034482
(87) International publication number: WO 2025/070639

(57) **Abstract**

Provided is a substrate separation apparatus capable of accurately separating a bonded substrate. The substrate separation apparatus (1) according to an embodiment includes a holding part (10) configured to hold both surfaces of a bonded substrate (S) formed by bonding a pair of substrates together, a rotational drive part (122) configured to rotate the holding part (10), a nozzle (30) configured to separate the bonded substrate (S) by injecting a fluid toward the outer periphery of the bonded substrate (S) under rotation, a nozzle movement part (40) configured to move the nozzle (30), an imaging part configured to capture an image of an outer circumferential surface (CS) of the bonded substrate (S) held by the holding part (10), and a control device (100) configured to control the nozzle movement part (40). The control device (100) controls a height adjustment mechanism (43) of the nozzle movement part (40) to align a position of the nozzle (30) with a position of a separation surface (RS) of the bonded substrate (S) detected from the image captured by a camera (431).

## Description

### TECHNICAL FIELD

The present disclosure relates to a substrate separation apparatus.

### BACKGROUND

In the process of manufacturing a three-dimensional semiconductor device, a technique of separating a bonded substrate formed by bonding two substrates is used to allow a layer formed on one substrate to be transferred to the other substrate, thereby forming a uniform thin film.

As such a technique for separating substrates, a technique has been proposed in which the front and back surfaces of a bonded substrate obtained by bonding two substrates are sandwiched and held between a pair of holding part (holders), and high-pressure water (water jet) is supplied from a nozzle toward a separation surface exposed at the outer periphery of the bonded substrate while rotating the bonded substrate, thereby separating the bonded substrate through the use of the wedge effect of a fluid.

### [Prior Art Document]

### Patent Document

Patent Document 1: Japanese Laid-Open Publication No. H11-005064

In order to ensure uniform separation of a bonded substrate, the fluid needs to be consistently and accurately applied to the separation surface. If the fluid deviates from the separation surface, the separation process due to the wedge effect will not proceed, resulting in uneven progress in the separation process in the bonded substrate surface. This may lead to defects such as cracks and chips. Therefore, a need has existed for accurate detection of the separation surface in the direction perpendicular to the front surface of the bonded substrate.

The present disclosure provides some embodiments of a substrate separation apparatus capable of accurately separating a bonded substrate.

### SUMMARY

According to one embodiment of the present disclosure, a substrate separation apparatus includes: a holding part configured to hold both surfaces of a bonded substrate formed by bonding a pair of substrates together; a rotational drive part configured to rotate the holding part; a nozzle configured to separate the bonded substrate by injecting a fluid toward the outer periphery of the bonded substrate under rotation; a nozzle movement part configured to move the nozzle; an imaging part configured to capture an image of an outer circumferential surface of the bonded substrate held by the holding part; and a control device configured to control the nozzle movement part, wherein the control device controls the nozzle movement part to align a position of the nozzle with a position of a separation surface of the bonded substrate detected from the image captured by the imaging part.

According to the embodiment of the present disclosure, the bonded substrate can be separated accurately.

### BRIEF DESCRIPTION OF DRAWINGS

FIG. 1 is a side view showing a substrate separation apparatus according to an embodiment.
FIG. 2 is a plan view showing a bonded substrate and a positioning part when the bonded substrate is loaded.
FIG. 3 is a plan view showing the bonded substrate and the positioning part when the bonded substrate is positioned before a separation process.
FIG. 4 is a plan view showing a displacement of a nozzle to a standby position, a separation start position, and a center separation position.
FIG. 5 is a plan view showing the bonded substrate, the positioning part, and the nozzle during a center separation of the bonded substrate.
FIG. 6 is a block diagram showing the configuration of a control device.
FIG. 7 is a flowchart showing a procedure for separating a bonded substrate according to an embodiment.
FIGS. 8A to 8H are explanatory diagrams showing a process from the loading of the bonded substrate to the separation of the bonded substrate according to an embodiment.
FIG. 9 is a flowchart showing a procedure for detecting an inclination of a nozzle.
FIG. 10 is a plan view showing a positional relationship between the nozzle and a camera when detecting the inclination of the nozzle.
FIG. 11A is an explanatory diagram showing a state of light reflected from an injected fluid, and FIG. 11B is a diagram showing an example of an image captured by the camera.
FIG. 12 is a graph showing changes in a detected height of an separation surface.
FIG. 13 is a flowchart showing a procedure for determining the height of the nozzle.
FIG. 14A is an explanatory diagram showing an outer circumferential surface and the separation surface as seen from the lateral side of the bonded substrate, FIG. 14B is an explanatory diagram showing a state of light reflected from the bonded substrate, and FIG. 14C is a diagram showing an example of an image captured by the camera.
FIG. 15 is a schematic diagram showing a positional relationship between the bonded substrate, the nozzle, and the camera in a modification.

### DETAILED DESCRIPTION

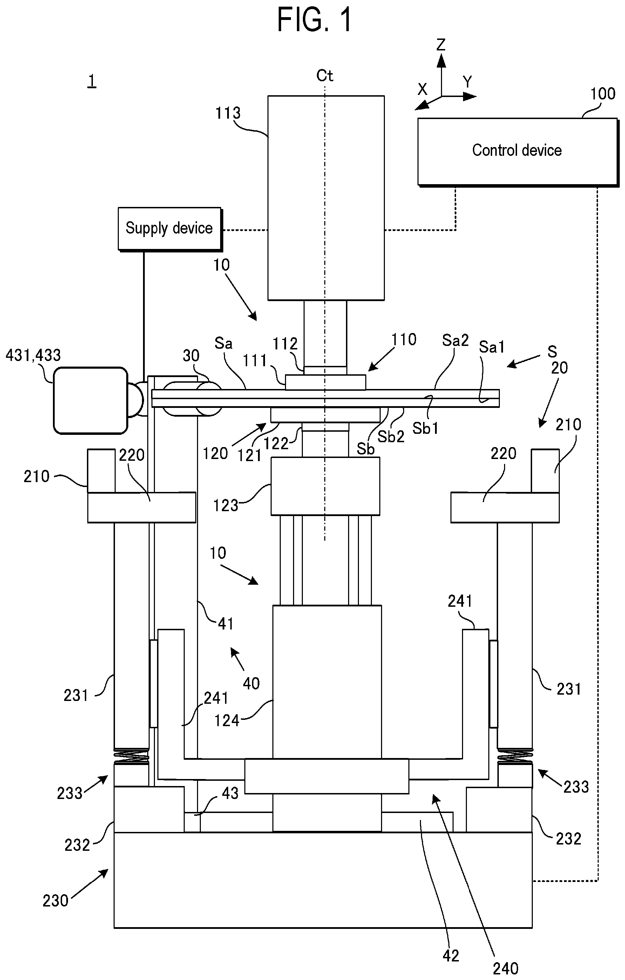

A substrate separation apparatus according to an embodiment will be described with reference to the drawings. The drawings are schematic diagrams. The size, proportions, and the like of each part are exaggerated for ease of understanding. As shown in FIG. 1, the substrate separation apparatus 1 separates a bonded substrate S by injecting a fluid from a nozzle 30. A grip part 210 and a mounting part 220, which are located in the foreground, are omitted in FIG. 1. In the following description, a direction along the rotation axis of the bonded substrate S is referred to as a Z direction, a direction in which the nozzle 30 injects a fluid in a plane perpendicular to the Z direction is referred to as a Y direction, and a direction perpendicular to the Y direction is referred to as an X direction. A rotation plane of the bonded substrate S is parallel to an XY plane. In this embodiment, the Z direction is a vertical direction, and the X and Y directions are horizontal directions. However, an installation direction of the substrate separation apparatus 1 is not limited thereto.

### [Bonded Substrate]

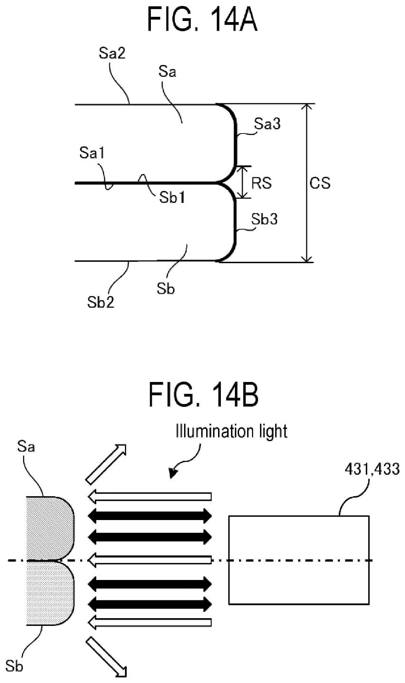

The bonded substrate S is a circular substrate formed by bonding a first substrate Sa and a second substrate Sb together. The first substrate Sa has a bonding surface Sa1, a surface Sa2 opposite to the bonding surface Sa1, and an outer circumferential surface Sa3 which connects the bonding surface Sa1 and the surface Sa2. The second substrate Sb has a bonding surface Sb1, a surface Sb2 opposite to the bonding surface Sb1, and an outer circumferential surface Sb3 which connects the bonding surfaces Sa1 and the surface Sa2. In other words, the bonded substrate S has a first surface Sa2 and a second surface Sb2, which are a pair of circular surfaces and are opposite the first substrate Sa and the second substrate Sb. Hereinafter, the surface Sa2 will be referred to as the first surface of the bonded substrate S, and the surface Sb2 will be referred to as the second surface of the bonded substrate S. Furthermore, as shown in FIG. 14A, in a recess formed by bonding the first substrate Sa and the second substrate Sb, a surface viewed from an outer circumferential surface CS of the bonded substrate S will be referred to as a separation surface RS. The outer circumferential surface CS of the bonded substrate S includes the outer circumferential surface Sa3 of the first substrate Sa, the separation surface RS, and the outer circumferential surface Sb3 of the second substrate Sb. The first substrate Sa is, for example, a substrate having a porous layer formed on a surface of a semiconductor wafer and a monocrystalline Si layer additionally formed on the porous layer.

The second substrate Sb is, for example, a substrate obtained by forming a monocrystalline Si layer on a surface of a semiconductor wafer. The bonded substrate S is formed by bonding the first substrate Sa and the second substrate Sb together via an insulating layer formed on the first substrate Sa or the second substrate Sb. In the following description, even if the bonded substrate S is a substrate including the first substrate Sa and the second substrate Sb separated from each other, it is still considered to be the bonded substrate S as long as the bonding surfaces Sa1 and Sb1 are overlapping.

### [Substrate Separation Apparatus]

The substrate separation apparatus 1 separates the first substrate Sa of the bonded substrate S from the porous layer and forms multiple monocrystalline Si layers on the second substrate Sb. As shown in FIG. 1, the substrate separation apparatus 1 includes a holding part 10, a positioning part 20, a nozzle 30, a nozzle movement part 40, and a control device 100.

### [Holding Part]

The holding part 10 holds both surfaces (Sa2 and Sb2) of the bonded substrate S and rotates the bonded substrate S. The holding part 10 includes a first holder 110 and a second holder 120.

### (First Holding Part)

The first holder 110 includes a first holding part 111 and a support mechanism 112. The first holding part 111 is a circular plate having a diameter smaller than a diameter of the surface of the bonded substrate S. The support mechanism 112 is connected to the center of a surface of the first holding part 111 via a Z-direction support shaft to rotatably support the first holding part 111 so that its center serves as a rotation center Ct. In this embodiment, the support shaft is connected via a pulley and a timing belt to a drive source that rotates a second holding part 121 (described below), and is configured to rotate in synchronization with the second holding part 121.

In this embodiment, a surface of the first holding part 111 fixed to the support mechanism 112 faces upward, and an opposite surface thereof faces downward. Although not shown, the first holding part 111 has a suction hole formed in a surface that contacts the bonded substrate S. By connecting an exhaust device to this suction hole, one surface of the bonded substrate S (the surface Sa2 of the first substrate Sa) can be suction-held by a negative pressure.

### (Second Holder)

The second holder 120 includes a second holding part 121, a rotational drive part 122, and an attachment/detachment drive part 123. The second holding part 121 is a circular plate having the same diameter as the first holding part 111. The rotational drive part 122 rotates the bonded substrate S. The rotational drive part 122 has a Z-direction drive shaft connected to the center of the second holding part 121, and rotatably supports the second holding part 121. The rotational drive part 122 includes a motor as a drive source for rotating the second holding part 121. The drive shaft is a motor shaft, and when the motor is operated, the second holding part 121 rotates about the rotation center Ct.

In this embodiment, a surface of the second holding part 121 attached to the rotational drive part 122 faces downward, and an opposite surface thereof faces upward so as to face the first holding part 111. In other words, the first holding part 111 and the second holding part 121 are arranged to face each other at a distance so that their rotation centers Ct coincide with each other. Although not shown, the second holding part 121 has a suction hole formed on a surface that contacts the bonded substrate S. By connecting an exhaust device to the suction hole, the other surface of the bonded substrate S (the surface Sb2 of the second substrate Sb) can be suction-held by a negative pressure.

The attachment/detachment drive part 123 causes the holding part 10 to hold the bonded substrate S. The attachment/detachment drive part 123 moves the second holding part 121 toward and away from the first holding part 111. The attachment/detachment drive part 123 has a cylinder as a drive source. The bonded substrate S is inserted between the first holding part 111 and the second holding part 121, which are spaced apart from each other. By allowing the attachment/detachment drive part 123 to move the second holding part 121 toward the first holding part 111, the bonded substrate S can be sandwiched and held between the first holding part 111 and the second holding part 121.

### [Positioning Part]

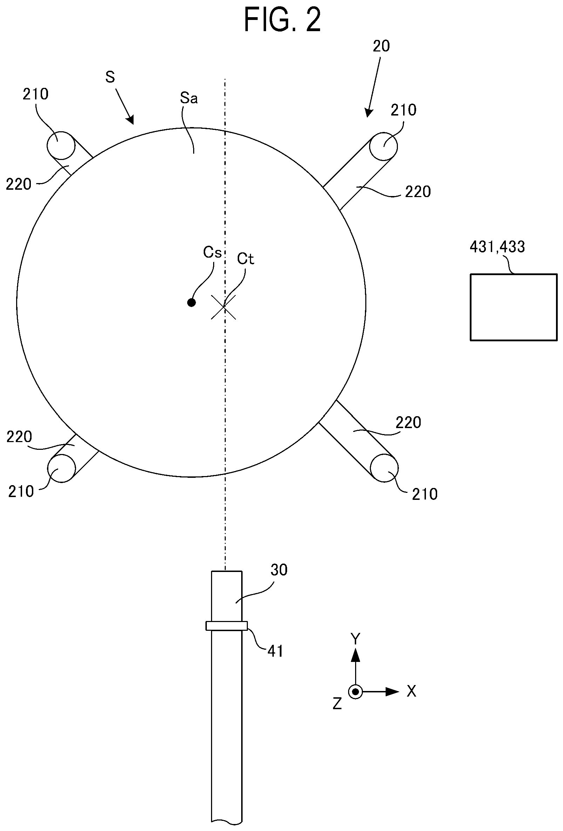

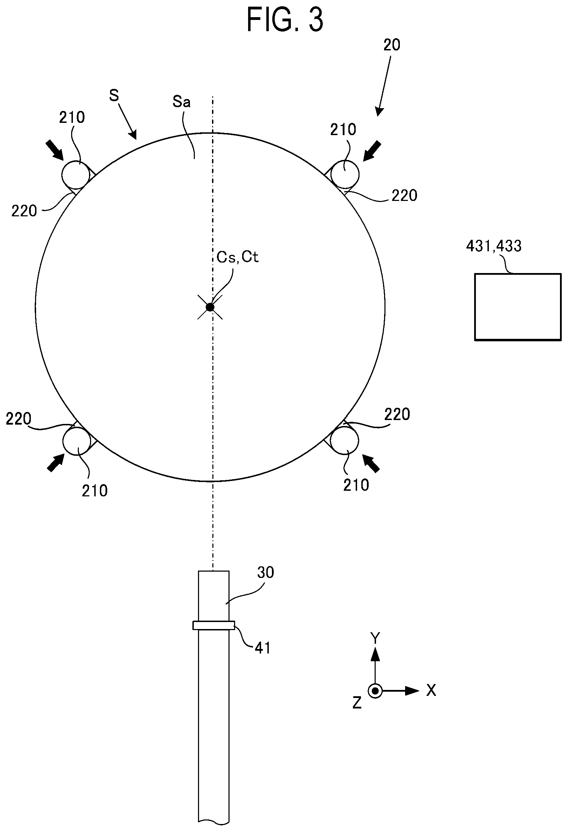

The positioning part 20 positions a center axis Cs of the bonded substrate S at a center axis Ct of the holding part 10 (*see* FIGS. 2 and 3). In other words, the center axis Cs of the bonded substrate S, which is arranged between the first holder 110 and the second holder 120, is aligned with the center axis Ct of the first holder 110 and the second holder 120. The positioning part 20 includes a grip part 210, a mounting part 220, an axial drive part 230, and an opening/closing drive part 240 (*see* FIG. 1).

### (Grip Part)

The grip part 210 grips an outer periphery of the bonded substrate S. The outer periphery of the bonded substrate S is a side surface extending along an outer edge of a circumference. Multiple grip parts 210 are arranged at equal intervals at positions around the holding part 10, i.e., at positions along the outer periphery of the bonded substrate S held by the holding part 10. In this embodiment, the grip parts 210 are four upright pins.

### (Mounting Part)

The mounting part 220 is configured to mount the bonded substrate S thereon. The mounting part 220 has a mounting surface that supports the bonded substrate S. Each grip part 210 is attached to the mounting part 220. Four mounting parts 220 are provided in one-to-one correspondence to the grip parts 210. In this embodiment, the surface of the bonded substrate S held by the second holder 120, i.e., the surface Sb2 of the second substrate Sb, is mounted on the mounting part 220.

### (Axial Drive Part)

The axial drive part 230 moves the grip part 210 and the mounting part 220 in an axial direction parallel to the rotation axis of the holding part 10. The axial drive part 230 includes a support column part 231, a biasing part 232, and an absorbing part 233. The support column part 231 is an upright member that supports the grip part 210 and the mounting part 220 at a tip end of the support column part 231. The biasing part 232 is provided to be axially movable by, for example, a drive mechanism such as a cam rotated by a cylinder. The absorbing part 233 is interposed between the biasing part 232 and the support column part 231 to transmit the movement of the biasing part 232 to the support column part 231 while absorbing vibrations from the bonded substrate S during the separation thereof. The absorbing part 233 may be, for example, a compression spring, a leaf spring, an elastic body made of rubber or resin, or a cylinder, as long as it is capable of absorbing vibrations during the separation thereof.

### (Opening/Closing Drive Part)

The opening/closing drive part 240 moves the grip part 210 and the mounting part 220 between a closed position where the grip part 210 contacts the outer periphery of the bonded substrate S and an open position where the grip part 210 is separated from the outer periphery of the bonded substrate S. The position of the grip part 210 is set so that the center Cs of the bonded substrate S is positioned at the rotation center Ct when the grip part 210 is in the closed position. The opening/closing drive part 240 includes an arm 241 that is moved in the radial direction of the bonded substrate S (centripetal direction and centrifugal direction relative to the rotation center Ct) by a drive mechanism such as a cam that is rotated by a cylinder (not shown). The support column part 231 is connected to the arm 241 so as to be axially movable.

### [Nozzle]

The nozzle 30 separates the bonded substrate S into the substrate Sa and the substrate Sb by injecting a fluid toward the outer periphery of the bonded substrate S under rotation. In this embodiment, the nozzle 30 injects a fluid toward the outer periphery of the bonded substrate S, which is held and rotated by the holding part 10.

The nozzle 30 of this embodiment is a spray device that sprays a high-pressure fluid onto an object. The nozzle 30 is connected via a pipe, a valve, and the like to a supply device 31 including a pump or the like that supplies the high-pressure fluid. The nozzle 30 is configured to be able to inject water (e.g., a water jet), which is a high-pressure fluid. The nozzle 30 has a very small hole diameter (0.1 mm to 1 mm), and the thickness of a tip end of the nozzle 30 is thick (1 cm to 5 cm) enough to withstand the high-pressure water. Furthermore, depending on the inclination of the axis of the hole provided in the nozzle 30 through which the fluid is injected, or the inclination of the nozzle 30 itself, the fluid may be sprayed from the nozzle 30 at a predetermined inclination. In other words, the fluid may be injected from the nozzle 30 at an angle θ° with respect to the horizontal direction.

As shown in FIG. 3, the axis of the nozzle 30 is located on an extension line of the radius of the positioned bonded substrate S, and the injection port at the tip of the nozzle 30 is directed toward the outer periphery of the bonded substrate S. Therefore, the nozzle 30 injects the fluid toward the center Cs in a direction parallel to the rotation plane of the bonded substrate S. However, the grip part 210 is located at a position that does not overlap with the extension line of the axis of the nozzle 30.

### (Nozzle Movement Part)

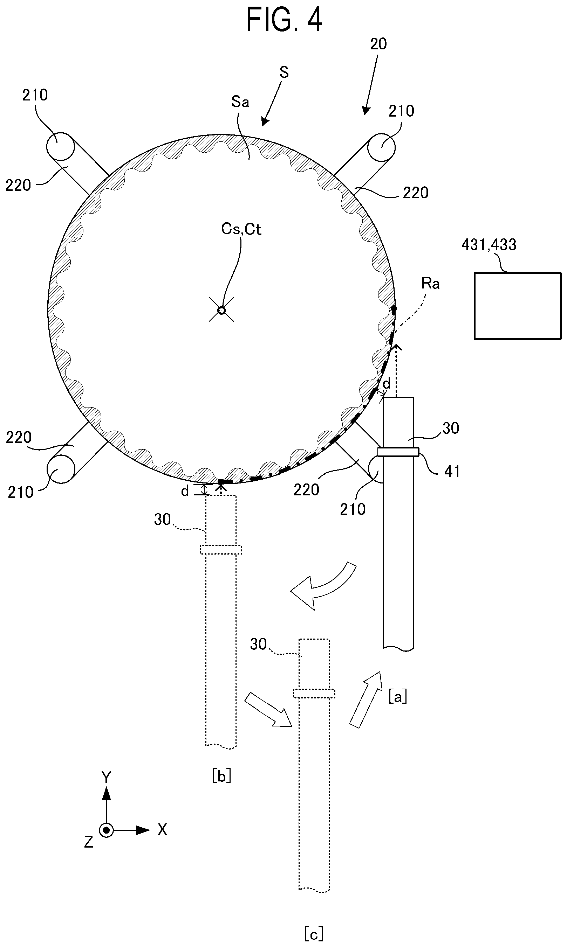

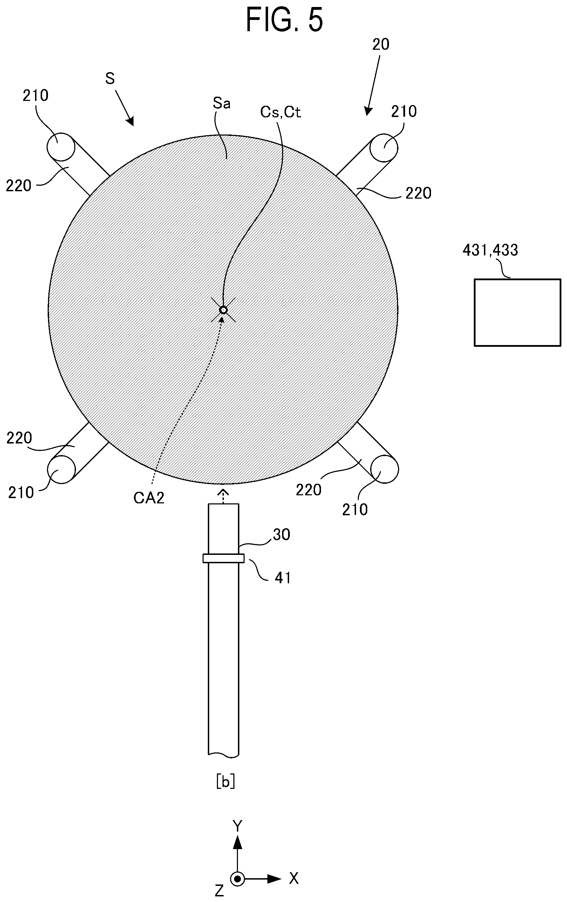

As shown in FIGS. 4 and 5, the nozzle movement part 40 changes the direction in which the fluid is injected from the nozzle 30 between a first direction that is a direction extending along the tangent to the outer periphery of the bonded substrate S and a second direction that is a direction facing toward the center axis Cs of the bonded substrate S. The first and second directions are parallel to each other. In other words, the nozzle 30 injects the fluid in two directions by changing its position from a separation start position [a] to a center separation position [b] in FIG. 4 without changing the injection direction of the fluid. The nozzle movement part 40 of this embodiment can move the nozzle 30 in a direction that extends along the outer periphery of the bonded substrate S. The nozzle movement part 40 includes an approach/retract mechanism 41, a position adjustment mechanism 42, and a height adjustment mechanism 43.

### (Approach/Retract Mechanism)

The approach/retract mechanism 41 moves the nozzle 30 between a standby position where the injection port is moved away from the outer periphery of the bonded substrate S and an injection position where the nozzle 30 is moved toward the outer periphery of the bonded substrate S so that the bonded substrate S can be separated by injecting a fluid. In other words, the approach/retract mechanism 41 moves the nozzle 30 along the Y direction. The approach/retract mechanism 41 may be, for example, a ball screw mechanism driven by a servo motor.

### (Position Adjustment Mechanism)

The position adjustment mechanism 42 moves the nozzle 30 between the separation start position [a] along the tangent to the outer periphery of the bonded substrate S held and rotated by the holding part 10 and the center separation position [b] facing the center axis Cs of the bonded substrate S. In other words, the position adjustment mechanism 42 moves the nozzle 30 along the X direction. The position adjustment mechanism 42 may be, for example, a ball screw mechanism driven by a servo motor.

As shown in FIG. 4, the nozzle 30 can move along an arc trajectory from the separation start position [a] to the center separation position [b] by the approach/retract mechanism 41 and the position adjustment mechanism 42. As a result, the fluid injected from the nozzle 30 is sprayed toward a partial region of the outer periphery of the bonded substrate S as indicated by Ra in FIG. 4. The partial region is a region including an arc with a central angle of 90 degrees on the outer periphery of the bonded substrate S. Since the bonded substrate S rotates at least during separation of the outer periphery, even if the fluid is injected to the partial region of the outer periphery, the injected fluid can be caused to reach the entire circumference.
Furthermore, as the separated portion of the bonded substrate S hatched in FIG. 4 grows wider, the fluid also reaches the central portion of the bonded substrate S through the gap between the first substrate Sa and the second substrate Sb. When separating the center of the bonded substrate S, the nozzle 30 is located at the center separation position [b] as shown in FIG. 5. Before the start of separation of the bonded substrate S and after the separation of the bonded substrate S, the approach/retract mechanism 41 and the position adjustment mechanism 42 move the nozzle 30 to a standby position [c] spaced apart from the outer periphery of the bonded substrate S.

A distance d between the injection port of the nozzle 30 positioned in the first direction and the outer periphery of the bonded substrate S is the same as a distance d between the injection port of the nozzle 30 positioned in the second direction and the outer periphery of the bonded substrate S. Thus, the injection port of the nozzle 30 in the first direction and the injection port of the nozzle 30 in the second direction can be positioned as close to the outer periphery of the bonded substrate S as possible.

### (Height Adjustment Mechanism)

The height adjustment mechanism 43 moves the nozzle 30 in the height direction (Z-axis direction). For example, a cylinder may be used as the height adjustment mechanism 43. That is, the height adjustment mechanism 43 moves the nozzle 30 along the Z-direction. The separation surface RS of the rotating bonded substrate S moves slightly up and down depending on the holding state and bending of the bonded substrate S. Furthermore, if the fluid is injected from the nozzle 30 at a predetermined inclination, when moving the nozzle 30 in the Z-axis direction, the height of the nozzle 30 needs to be adjusted in the up-down direction in consideration of the inclination of the fluid injected from the nozzle 30 in order to accurately hit the fluid (hereinafter referred to as injected fluid) on the separation surface RS. The height adjustment mechanism 43 includes a camera 431 as an imaging part, and moves the nozzle 30 in the height direction based on detection results of the camera 431.

The camera 431 may have a depth of field of 35 µm to 50 µm. As shown in FIG. 4, the camera 431 is positioned at a 90° angle with respect to the axis of the nozzle 30 and on an extension line of the diameter of the bonded substrate S. In the XY plane, the axis of the nozzle 30 coincides with the injection direction of the injected fluid injected from the nozzle 30. The camera 431 may be installed on a fixed stand, or may be installed on a lifting table or the like so that the height of the camera 431 can be adjusted to match the height of the bonded substrate S held by the holding part 10.

It is desirable that the camera 431 be located at a certain distance from the injected fluid in order to reduce the influence of water droplets when capturing an image.

A light 433, which is an irradiation part, is provided near the camera 431 and is parallel to the optical axis of the camera 431. The irradiation light from the light 433 is irradiated in a direction perpendicular to the injected fluid. The camera 431 detects the position of the injected fluid by detecting the reflected light (specularly reflected light) of the irradiated irradiation light that is specularly reflected from the surface of the injected fluid. The camera 431 is also installed at a position where it can capture an image of the outer circumferential surface CS including the separation surface RS of the loaded bonded substrate S. When the bonded substrate S is held by the holding part 10, the focal position of the camera 431 is located on the separation surface RS of the bonded substrate S.

The camera 431 may be a camera that images only one point on the outer circumferential surface CS of the stationary bonded substrate S, but is preferably a camera that can image, at a predetermined angular interval or continuously, the entire circumference of the outer circumferential surface CS of the bonded substrate S rotating at a low speed. That is, the outer circumferential surface CS of the bonded substrate S held by the holding part 10 is not necessarily held at the same height due to reasons such as the dimensional accuracy of the holding part 10 and the bonded substrate S, and is expected to have a slight deviation in height in the circumferential direction. Therefore, when the separation operation is performed while the bonded substrate S is being rotated, the height of the nozzle 30 can be adjusted according to the rotation angle and height of the bonded substrate S, which makes it possible to reliably inject the fluid onto the separation surface RS.

### [Control Device]

The control device 100, which is a device for controlling the substrate separation apparatus 1, controls the operations of the holding part 10, the positioning part 20, the nozzle 30 and the nozzle movement part 40. The control device 100 can be implemented, for example, by a dedicated electronic circuit or a computer running with a predetermined program.

More specifically, the control device 100 controls the rotation and movement of the second holding part 121 by controlling the rotational drive part 122 and the attachment/detachment drive part 123. The control device 100 also controls the movement of the grip part 210 and the mounting part 220 by controlling the axial drive part 230 and the opening/closing drive part 240. Furthermore, the control device 100 controls the injection of fluid from the nozzle 30 by controlling the supply device 31, and also controls the movement of the nozzle 30 by controlling the approach/retract mechanism 41 and position adjustment mechanism 42 provided in the nozzle movement part 40.

Next, the alignment of the position of the nozzle 30 with the separation surface RS of the bonded substrate S will be described.

### (1) Calculation of Movement Amount of Nozzle 30 based on the Inclination of Injected Fluid

The control device 100 detects the inclination of the fluid injected from the nozzle 30 based on the image captured by the camera 431. Based on the detected inclination of the injected fluid and the distance from the injection port of the nozzle 30 to an arbitrary processing position on the separation surface RS to which the injected fluid is supplied, the control device 100 controls the nozzle movement part 40 to align the height position of the nozzle 30 with the height position of the separation surface RS.

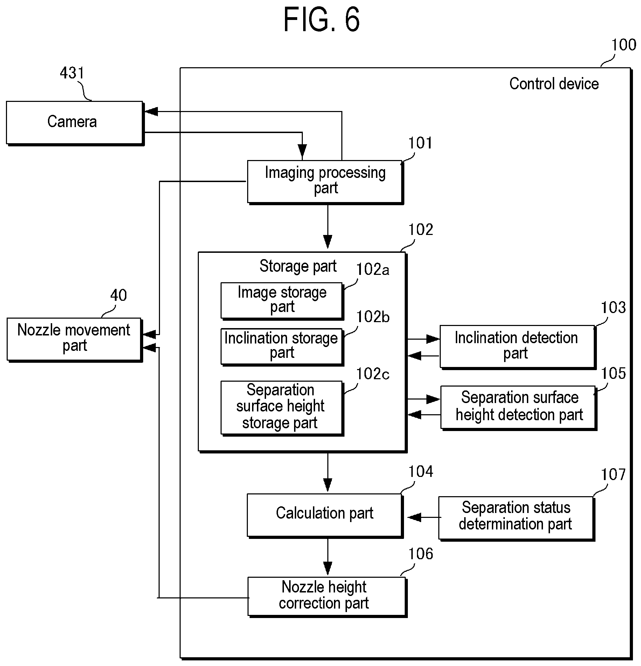

Therefore, as shown in FIG. 6, the control device 100 includes an imaging processing part 101 that controls the imaging timing of the camera 431, the rotation of the bonded substrate S, the movement of the nozzle 30, and the like.

Before the bonded substrate S is loaded, the imaging processing part 101 moves the nozzle 30 to a position where an image of the injected fluid can be captured by the camera 431 can capture, and then captures an image of the injected fluid. The captured image is stored in an image storage part 102a of a storage part 102. An inclination detection part 103 detects the inclination of the injected fluid based on the captured image and stores the detected inclination in an inclination storage part 102b. A calculation part 104 calculates the amount of movement of the nozzle 30 so as to align the height position of the nozzle 30 with the height of the separation surface RS, based on the detected inclination of the injected fluid and the distance from the injection port of the nozzle 30 to an arbitrary processing position on the separation surface RS. In other words, the calculation part 104 calculates the amount of movement of the nozzle 30 in the height direction so that the nozzle 30 is positioned at a position where the injected fluid injected from the nozzle 30 hits the separation surface RS.

### (2) Height Correction Control based on Changes in the Height of Separation Surface

The control device 100 corrects the calculated amount of movement of the nozzle 30 using a correction amount based on the height of the separation surface RS, which moves up and down in accordance with the rotation of the bonded substrate S, and controls the movement of the nozzle 30 in the height direction.

In order to calculate the correction amount based on the height of the separation surface RS, which moves up and down in accordance with the rotation of the bonded substrate S, the imaging processing part 101 captures images of the outer circumferential surface CS of the bonded substrate S, which is held by the holding part 10 and is rotated, for one or more revolutions before the injection of the injected fluid. The storage part 102 includes a separation surface height storage part 102c that stores the rotation angle of the bonded substrate S at the time of image capture and the position of the separation surface RS of the bonded substrate S detected from the image captured by the camera 431 in association with each other. A separation surface height detection part 105 detects changes in the position of the separation surface RS of the bonded substrate S using a specific position of the bonded substrate S as a reference. For example, if the bonded substrate S is a semiconductor wafer, the position of a notch is used as a reference. By using the position of the notch as a reference, the amount of change in the height of the separation surface RS of the bonded substrate S is detected in association with the angle of separation from the notch position. In order to detect the amount of change in the height of the separation surface RS of the bonded substrate S, it is necessary to detect the height position of the separation surface RS for one or more revolutions. However, by using the position of the notch as a reference, it is possible to easily determine the height position of the separation surface RS for one circumference of the rotating bonded substrate S.

The control device 100 includes a calculation part 104 that refers to the values stored in the separation surface height storage part 102c and calculates the amount of movement of the nozzle 30 based on the height of the separation surface RS and the rotation angle of the bonded substrate S. The calculation part 104 refers to the inclination of the injected fluid stored in the inclination storage part 102b and calculates the amount of movement of the nozzle 30 based on the inclination of the injected fluid and the distance from the injection port of the nozzle 30 to an arbitrary processing position on the separation surface RS. A nozzle height correction part 106 calculates the correction amount for the height of the nozzle 30 based on a change in the height of the separation surface RS. The nozzle height correction part 106 outputs a control signal to the nozzle movement part 40 based on the amount of movement of the nozzle 30 calculated by the calculation part 104 and the calculated correction amount for the height of the nozzle 30.

The control device 100 includes a separation status determination part 107 that determines the separation status from the images captured by the camera 431. The separation status determination part 107 determines the progress of the separation process by comparing the image captured by the camera 431 with a reference image for the separation status at each stage, which is pre-stored in the storage part 102. More specifically, as the separation process progresses, the fluid infiltrates the bonding surfaces Sa1 and Sb2 of the first substrate Sa and the second substrate Sb, thereby increasing the size of the recess between the first substrate Sa and the second substrate Sb, i.e., increasing the size of the separation surface RS. Therefore, by comparing the reference image at the separation stage of the outer periphery of the bonded substrate S with the image captured by the camera 431, it can be determined that the outer periphery has separated if the images match. Alternatively, it may be possible to adopt a method of calculating the distance between the two substrates in the bonded substrate S from the captured image, and determining the degree of separation or the completion of separation if the distance exceeds a preset threshold value. Based on the result of this determination, the control device 100 can control the movement of the nozzle 30 and the injection time and intensity of the injection fluid injected from the nozzle 30.

### [Operation]

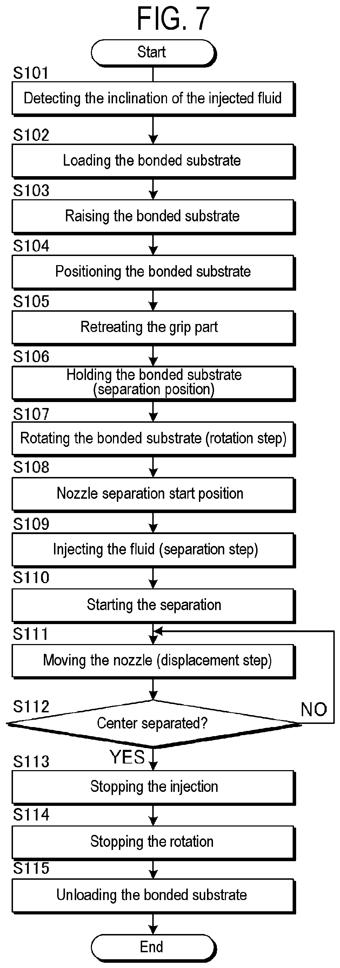

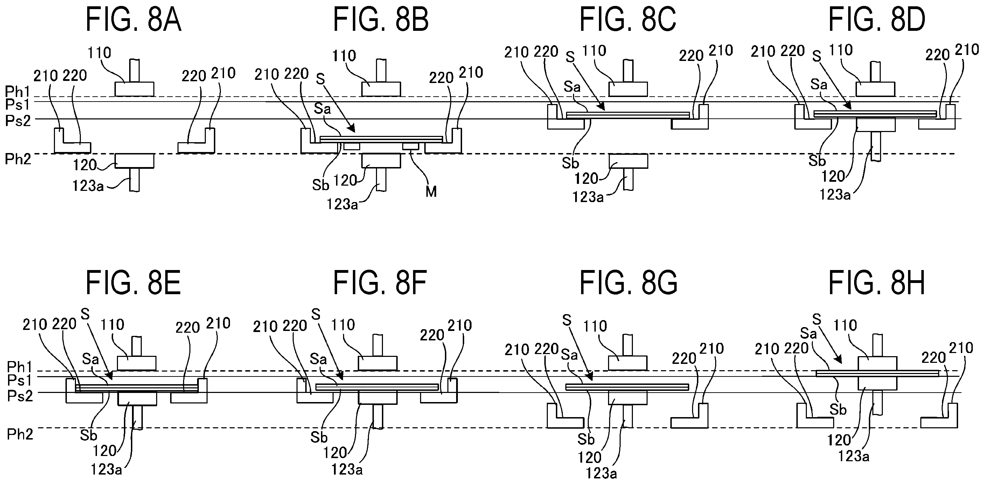

The operation of the substrate separation apparatus 1 will be described with reference to the flowchart shown in FIG. 7 and the explanatory diagram shown in FIGS. 8A to 8H, in addition to the above-described FIGS. 1 to 6. In FIGS. 8A to 8H, Ph1 is a fixed reference position of the lower surface of the first holder 110, and Ph2 is a delivery position which is the position of the lower surface of the mounting part 220 when the mounting part 220 delivers the bonded substrate S to and from a robot arm M. Ps1 is a separation position which is the height position of the lower surface of the second substrate Sb when the bonded substrate S is sandwiched between the first holder 110 and the second holder 120 and is separated by injecting the fluid from the nozzle 30 while being rotated. Ps2 is a receiving position which is the position of the upper surface of the mounting part 220 when the positioning part 20 receives the bonded substrate S from the holding part 10.

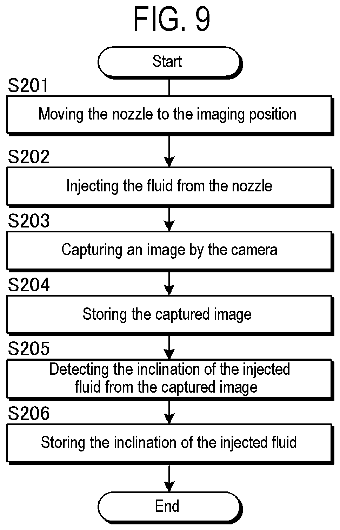

First, the substrate separation apparatus 1 detects the inclination of the injected fluid before the bonded substrate S is loaded (S101). FIG. 9 is a flowchart showing the procedure for detecting the inclination of the injected fluid in S101.

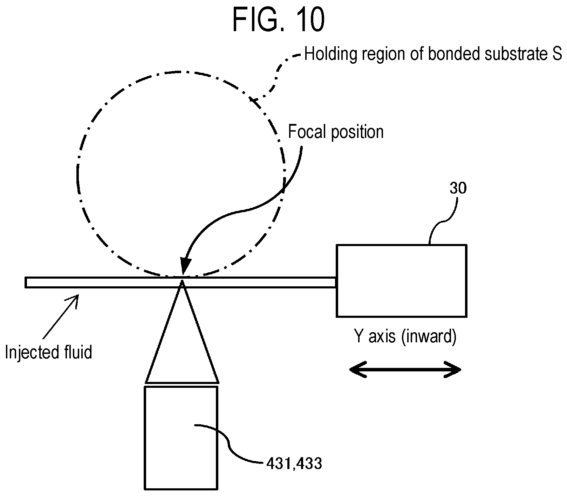

In order to detect the inclination of the injected fluid, the imaging processing part 101 moves the nozzle 30 to an imaging position (S201). As shown in FIG. 10, the imaging position is a position where the injected fluid overlaps with the focal position of the camera 431. After the nozzle 30 is moved, the imaging processing part 101 causes the camera 431 to capture an image of the fluid injected from the nozzle 30 (S202 and S203).

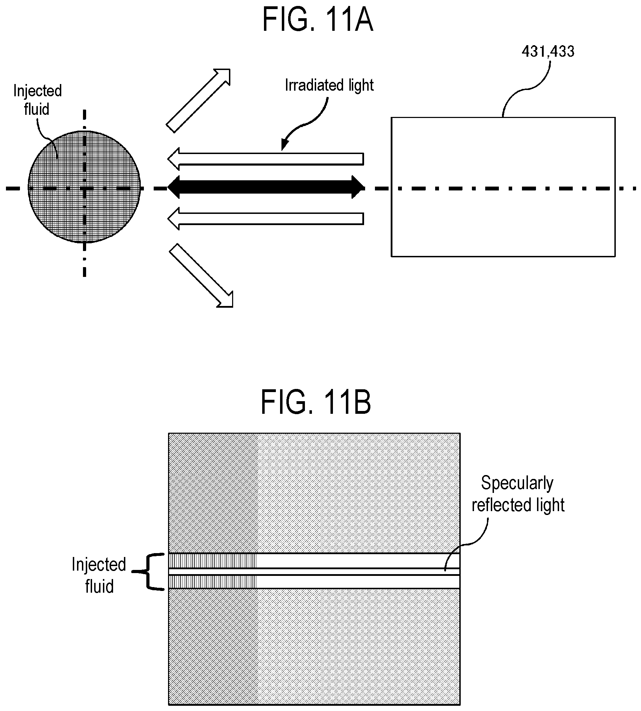

FIG. 11A is an explanatory diagram showing the state of the light reflected from the surface of the injected fluid. As shown in FIG. 11A, the light irradiated from the light 433 to the central portion of the injected fluid, which is indicated by the black arrow, is specularly reflected, but is diffused at the peripheral portion of the injected fluid. For example, in the case of an injected fluid having a diameter of 100 µm, the light is specularly reflected at approximately 20 µm from the center. Therefore, when the injected fluid irradiated with the light 433 is imaged with the camera 431, the central portion appears bright (high in brightness) in the form of a straight line, while the peripheral portion appears dark (low in brightness) as shown in the captured image of FIG. 11B. In other words, by irradiating the injected fluid with the light from the light 433, an image having clear contrast between the central portion and the peripheral portion can be captured. The captured image is stored in the image storage part 102a (S204).

Next, the inclination detection part 103 detects an inclination from the captured image (S205). The inclination detection part 103 detects the inclination of the injected fluid from the captured image stored in the image storage part 102a, and stores the detected inclination in the inclination storage part 102b (S206). As shown in FIGS. 11A and 11B, the central portion of the injected fluid appears in the form of a straight line. Therefore, the inclination of the injected fluid can be detected by detecting the inclination angle of this straight line. As described above, the injected fluid in the captured image has clear contrast between the central portion and the peripheral portion, which makes it possible to accurately detect the inclination. By going through the above-described S201 to S206, the process of detecting the inclination of the injected fluid (S101) is completed.

At this time, the second holder 120 is located at a position spaced apart from the first holder 110 (FIG. 8A). The grip part 210 and the mounting part 220 are located at the delivery position Ph2 and also at the open position. The robot arm M of the transfer device loads the bonded substrate S and mounts the bonded substrate S on the mounting part 220 (FIG. 8B and step S102). The grip part 210 rises to raise the bonded substrate S (FIG. 8C). Furthermore, the second holder 120 rises to contact the lower surface of the second substrate Sb, thereby raising the bonded substrate S and slightly separating the bonded substrate S from the mounting part 220 (FIG. 8D and step S103).

As shown in FIG. 3, the grip part 210 moves to the closed position to grip the outer periphery of the bonded substrate S, thereby positioning the center axis Cs of the bonded substrate S at the center axis Ct (FIG. 8E and step S104). Thereafter, the grip part 210 moves to the open position (FIG. 8F) and retreats together with the mounting part 220 to the delivery position Ph2 (FIG. 8G and step S105). Then, the second holder 120 rises to bring the bonded substrate S into contact with the first holder 110 and to sandwich and hold the bonded substrate S. The bonded substrate S is located at the separation position Ps1, and the bonded substrate S is sucked and held by the negative pressure at the suction hole (FIG. 8H and step S106).

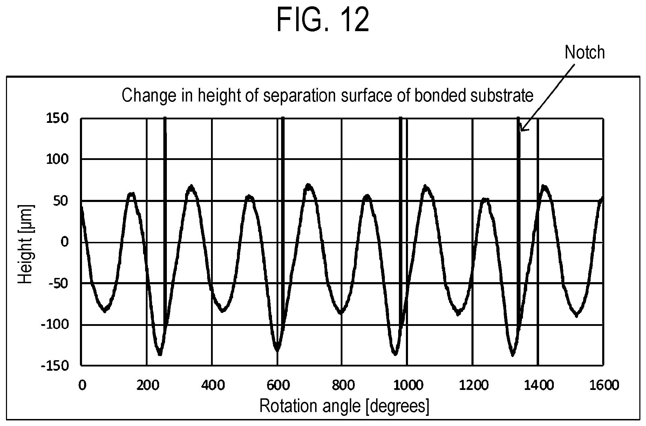

In this state, the second holder 120 is rotated to rotate the bonded substrate S together with the first holder 110 (rotation process: step S107). When the bonded substrate S is held and rotated by the holding part 10, the height of the separation surface RS on the side surface of the bonded substrate S may fluctuate slightly depending on the holding state and bending of the bonded substrate S. FIG. 12 is a graph showing the height of the separation surface RS with respect to the rotation angle. In FIG. 12, the rotation angles at which straight lines extending along the vertical axis direction appear between 200 degrees and 400 degrees, 600 degrees and 800 degrees, 800 degrees and 1000 degrees, and 1200 degrees and 1400 degrees are the rotation angles at which a notch appears when the bonded substrate S rotates one or more revolutions. In other words, the change in height between the notch at a certain rotation angle and the notch appearing next (between the above-mentioned straight lines) can be determined as a change in height for one rotation. As shown in FIG. 12, the height of the separation surface RS is changed within a range of ±150 µm when the reference height for each rotation of the bonded substrate S is set to 0. The control device 100 corrects the position of the nozzle 30 in accordance with the change in the height of the separation surface RS, and controls the injected fluid so that it does not deviate from the separation surface RS.

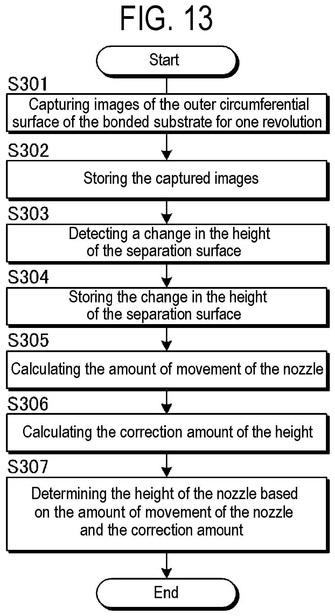

FIG. 13 is a flowchart showing a procedure for determining the height of the nozzle 30 in accordance with changes in the height of the separation surface. When the bonded substrate S is held by the first holder 110 and the second holder 120, the imaging processing part 101 causes the camera 431 to capture an image of the outer circumferential surface CS for one revolution while rotating the bonded substrate S (S301). The rotation of the bonded substrate S causes the height of the separation surface RS to moves up and down. By adjusting the focal length and position of the camera 431, the separation surface RS is prevented from falling outside the angle of view of the camera 431 even if the separation surface RS moves up and down.

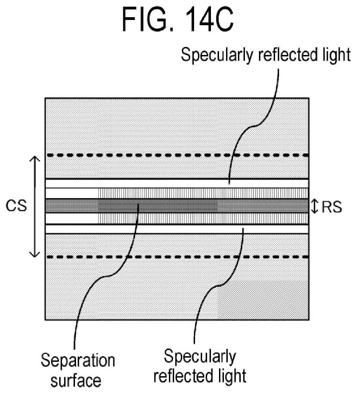

FIG. 14B is an explanatory diagram showing the state of the light reflected from the bonded substrate S. As shown in FIG. 14B, the light irradiated from the light 433 is specularly reflected at the portion of the outer circumferential surface CS of the bonded substrate S where the illumination light is perpendicularly incident as indicated by the black arrow, but the light is diffused at curved portion where the outer circumferential surface CS of the bonded substrate S is connected to the surface Sa2. Therefore, when the bonded substrate S irradiated with the light 433 is imaged, as in the image shown in FIG. 14C, the central portion of the outer circumferential surface Sa3 of the first substrate Sa and the central portion of the outer circumferential surface Sb3 of the second substrate Sb on the outer circumferential surface CS of the bonded substrate S become specularly reflective surfaces that specularly reflect the irradiated light. Thus, the specularly reflected light is detected, resulting in a bright (high brightness) image. In contrast, the central portion including the separation surface RS between the first substrate Sa and the second substrate Sb leads to a dark (low brightness) image. That is, by irradiating the outer circumferential surface CS of the bonded substrate S with the light 433, it is possible to capture an image with clear contrast between the outer circumferential surface Sa3 of the first substrate Sa and the outer circumferential surface Sb3 of the second substrate Sb, and the central portion sandwiched between them. The captured image is stored in the image storage part 102a (S302).

Next, the separation surface height detection part 105 detects a change in the height of the separation surface RS from the captured image (S303). The separation surface height detection part 105 detects the region between the two specularly reflective surfaces as the separation surface RS. Specifically, the separation surface height detection part 105 detects a region several µm wide from the center between the two linear regions where the specularly reflected light is detected, as the separation surface RS. The separation surface height detection part 105 can accurately detect the height of the separation surface RS by using a captured image with high contrast. The separation surface height detection part 105 transmits information about the detected height of the separation surface RS to the separation surface height storage part 102c. The separation surface height storage part 102c stores the height of the separation surface RS detected from the captured image in association with the rotation angle of the bonded substrate S (S304).

The calculation part 104 calculates the amount of movement of the nozzle 30 based on the relationship between the inclination of the injected fluid and the distance from the injection port of the nozzle 30 to an arbitrary processing position on the separation surface RS (S305). Thereafter, the nozzle height correction part 106 calculates the correction amount of the height of the nozzle 30 (S306). A control signal is output to the nozzle movement part 40 based on the amount of movement of the nozzle 30 calculated by the calculation part 104 and the calculated correction amount of the height of the nozzle 30 (S307).

The height position of the nozzle 30 is determined by going through the above-described steps S301 to S307. Next, the nozzle 30 is moved from the standby position [c] shown in FIG. 4 and is positioned at the separation start position [a] (step 108). Based on the height position determined in S307, the height position of the nozzle 30 is also adjusted. Then, the nozzle 30 injects the fluid toward the outer periphery of the bonded substrate S (separation step: step S109). This starts separation of the bonded substrate S (step S110).

The nozzle 30 is moved so as to follow the separation surface RS of the bonded substrate S (displacement step: step S111). Here, as described above, the distance of the nozzle 30 from the separation surface RS and the height of the separation surface RS are changed with the rotation of the bonded substrate S and the transition of the separated portion on the separation surface RS. By changing the height of the nozzle 30 based on these changes, the injected fluid injected from the nozzle 30 hits the separation surface RS accurately, and the separation step progresses.

Then, when the bonding surface Sa1 and the bonding surface Sb1 are separated at the location corresponding to the center axis Cs as the separation progresses (YES in step S112), the injection of the fluid from the nozzle 30 stops (step S113). The rotation of the first holder 110 and the second holder 120 stops, and therefore the rotation of the bonded substrate S stops (step S114).

Thereafter, the negative pressure in the first holder 110 and the second holder 120 is released, and the second holder 120 is lowered to deliver the bonded substrate S to the mounting part 220. The robot arm M of the transfer device lifts up the bonded substrate S from the underside of the bonded substrate S, and unloads the bonded substrate S (*see* FIGS. 8B and 8A (step S115).

### [Effects]

(1) The substrate separation apparatus 1 of this embodiment includes a holding part 10 configured to hold a bonded substrate S formed by bonding a pair of substrates together, a rotational drive part 122 configured to rotate the holding part 10, a nozzle 30 configured to separate the bonded substrate S by injecting a fluid toward an outer periphery of the bonded substrate S under rotation, a nozzle movement part 40 configured to move the nozzle 30, an imaging part configured to capture an image of an outer circumferential surface CS of the bonded substrate S held by the holding part 10, and a control device 100 configured to control the nozzle movement part 40. The control device 100 controls a height adjustment mechanism 43 of the nozzle movement part 40 to align the height position of the nozzle 30 with the position of the separation surface RS of the bonded substrate S detected from the image captured by the camera 431.
   This makes it possible to accurately detect the separation surface RS of the bonded substrate S in the height direction and always accurately hit the fluid onto the separation surface RS, whereby the separation process is reliably executed by the wedge effect. As a result, separation can proceed uniformly in the plane of the bonded substrate S. By transferring a layer formed on one substrate to another substrate, it becomes possible to form a uniform thin film on the substrate without causing defects such as cracks or chips in the substrate.
(2) The camera 431 captures images of the outer circumferential surface CS of the bonded substrate S, which is held and rotated by the holding part 10, for one or more revolutions. The control device 100 stores the rotation angle of the bonded substrate S and the position of the separation surface RS of the bonded substrate S detected from the images captured by the camera 431 in association with each other, and controls the height adjustment mechanism 43 of the nozzle movement part 40 to align the height position of the nozzle 30 with the position of the separation surface RS.
   Therefore, even if the height of the bonded substrate S varies slightly depending on the rotation angle, it is possible to accurately grasp the position of the separation surface RS of the bonded substrate S detected from the image captured by the camera 431, and it is possible to accurately align the injected fluid with the separation surface RS over the entire outer periphery of the bonded substrate S.
(3) The camera 431 captures an image of the injected fluid injected from the nozzle 30, and the control device 100 detects the inclination of the injected fluid injected from the nozzle 30 based on the image captured by the camera 431 and controls the height adjustment mechanism 43 of the nozzle movement part 40 to align the height position of the nozzle 30 with the height of the separation surface RS based on the detected inclination of the injected fluid and the distance from an injection port of the nozzle 30 to the separation surface RS. In other words, the height direction movement of the nozzle 30 is controlled so that the nozzle 30 is positioned at a position where the injected fluid injected from the nozzle 30 hits the separation surface RS.
   Therefore, even if the fluid injected from the nozzle 30 is inclined, the height adjustment mechanism 43 can be controlled to align the height position of the nozzle 30 with the separation surface RS in consideration of the amount of inclination, so that the fluid is accurately sprayed onto the separation surface RS. As a result, it is possible to eliminate the possibility that the fluid moves away from the separation surface RS when the separation of the bonded substrate S progresses, and that the injected fluid collides with other portions of the bonded substrate S and causes damage to the substrate. In particular, since the injected fluid turns into a mist at a location far from the position of injection from the nozzle 30, it is necessary to bring the nozzle 30 closer to the separation surface RS. However, the distance between the fluid and the processing point by the nozzle 30 varies depending on the location, and the inclination angle of the injected fluid also varies accordingly. Therefore, the act of detecting the inclination of the injected fluid and setting the appropriate height of the nozzle 30 accordingly is extremely effective for performing an appropriate separation work.
(4) The substrate separation apparatus 1 includes a light 433 configured to irradiate the outer circumferential surface CS of the bonded substrate S or the fluid injected from the nozzle 30 with illumination light in a coaxial direction with the camera 431. Therefore, the camera 431 can directly capture the coaxial reflected light generated when the illumination light from the light irradiation part is incident on the vicinity of the separation surface RS or the fluid injected from the nozzle 30 and is reflected therefrom. This allows for a clearer image of the separation surface RS to be obtained compared to a case where an image is captured using scattered light such as natural light or indoor light, thereby improving the alignment accuracy for the nozzle 30. Furthermore, the light 433 provides a large amount of irradiated light or reflected light, which improves the accuracy and contrast of the captured image and facilitates image analysis when detecting the position of the separation surface RS or the position of the fluid injected from the nozzle 30.
(5) The camera 431 captures an image of the outer circumferential surface CS of the bonded substrate S after separation has started and before separation is completed, and the control device 100 determines the separation status from the image captured by the camera 431. Therefore, the camera 431 can determine the separation status of the bonded substrate S in addition to aligning the nozzle 30, and the control device 100 can control the fluid injection time, fluid injection intensity, fluid injection position, and the like based on the determination result, thereby more accurately executing the separation process for the bonded substrate S.

### [Modifications]

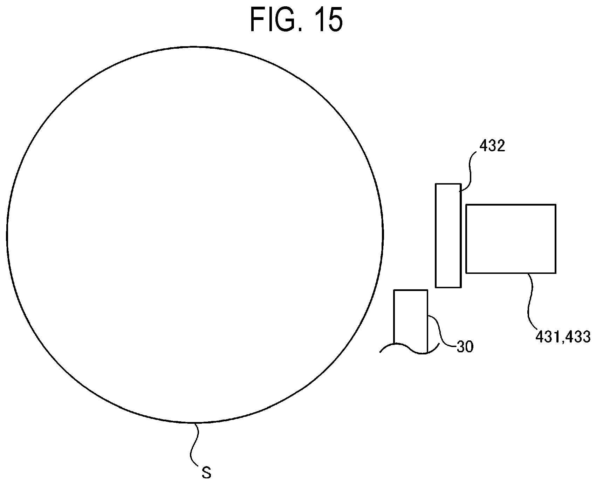

The following modifications are also applicable to this embodiment.
(1) As shown in FIG. 15, a plate 432 for preventing water droplets from adhering to the camera 431 may be provided in front of the lens of the camera 431 between the camera 431 and the bonded substrate S so as to be located closer to the camera 431 than the injection port of the nozzle 30. The plate 432 is preferably made of transparent glass or plastic. By providing the plate 432 for water droplet adhesion prevention, it is possible to prevent water droplets from adhering to the imaging part (camera 431). In particular, when determining the separation status from the images captured by the imaging part as described above, even if the imaging part images the injected fluid to align the nozzle 30 while the bonded substrate S is held by the holding part 10, it is possible to prevent water droplets from adhering to the imaging part, thereby preventing interference with subsequent imaging of the separation surface RS of the bonded substrate S. The plate 432 may be provided integrally with the camera 431 or as a separate component.
(2) If the inclination that occurs due to factors such as the shape of the nozzle 30 and the like when the injected fluid reaches the separation surface RS from the tip of the nozzle 30 can be almost ignored in the separation operation, there is no need to detect the inclination angle of the injected fluid by the image analysis described in the embodiment. Furthermore, when the inclination angle is determined in advance by simulation or calculation, it is possible to reflect that value in the correction amount in the height direction of the separation surface RS and the nozzle 30 acquired by the camera 431. In this case, there is also no need to detect the inclination angle of the injected fluid by the image analysis described in the embodiment.
(3) If the amount of displacement in the rotation angle of the bonded substrate S due to factors such as the thickness, material, and diameter of the bonded substrate S can be almost ignored in the separation operation, it is also possible to determine the amount of movement of the nozzle 30 by imaging only one point on the bonded substrate S without imaging the outer circumferential surface CS for one or more revolutions.
(4) Depending on the brightness around the separation surface RS, the light 433 that irradiates the outer periphery of the bonded substrate S or the fluid injected from the nozzle 30 with illumination light may not be necessary. Furthermore, if the position of the separation surface RS and the inclination angle of the injected fluid can be determined from the captured image without making the illumination light coaxial with the optical axis of the camera 431, the installation position of the light 433 may also be changed as appropriate.
(5) As the camera 431, in addition to a typical camera that captures visible light, a camera that captures images of the separation surface RS or the fluid using infrared light, radiation, or the like may also be used, and in addition to a camera that captures still images, a camera that captures moving images such as a video camera may also be used. Furthermore, there is no limit to the number of cameras 431. In the case of detecting positions at multiple locations on the outer periphery of the bonded substrate S, multiple cameras 431 may be installed in conformity with the detection positions.
(6) Instead of or in parallel with determining the separation status from the image captured by the camera 431, the progress of separation of the bonded substrate S may be determined based on a time previously determined by experiment or simulation, and the nozzle 30 may be moved accordingly.
(7) When determining the separation status, it is preferable that the timing of image capture by the camera 431 is at least one or more points after the start of separation and before the completion of separation. It is also possible to capture an image after the completion of separation. In addition, the start and completion of separation of the bonded substrate S may be determined based on the movement position of the nozzle 30, and the success or failure of the separation work may be determined from the captured images obtained before and after that.
(8) In the illustrated embodiment, the bonded substrate S is rotated horizontally. However, it is also possible to rotate the bonded substrate S vertically by holding the bonded substrate S from the left and right sides with the holding part 10. In this case, the nozzle movement part 40 moves the nozzle 30 horizontally, i.e., in a direction parallel to the center axis of rotation of the bonded substrate S, instead of performing the height direction adjustment described in the embodiment.

### [Other Embodiments]

The present disclosure is not limited to the above-described embodiment and includes other embodiments. The present disclosure also includes combinations of all or any of the above-described embodiments and other embodiments. Furthermore, various omissions, substitutions, and modifications may be made to these embodiments without departing from the scope of the present disclosure. These modifications are also included in the present disclosure.

### EXPLANATION OF REFERENCE NUMERALS

1: substrate separation apparatus, 10: holding part, 20: positioning part, 30: nozzle, 31: supply device, 40: nozzle movement part, 41: approach/retract mechanism, 42: position adjustment mechanism, 43: height adjustment mechanism, 100: control part, 101: imaging processing part, 102: storage part, 102a: image storage part, 102b: inclination storage part, 102c: separation surface height storage part, 103: inclination detection part, 104: separation surface height detection part, 105: calculation part, 106: nozzle height correction part, 107: separation status determination part, 110: first holder, 111: first holding part, 112: support mechanism, 112a: support shaft, 120: second holder, 121: second holding part, 122: rotational drive part, 122a: drive shaft, 123: attachment/detachment drive part, 210: grip part, 220: mounting part, 230: axial drive part, 231: support column part, 232: biasing part, 233: absorption part, 240: opening/closing drive part, 241: arm, 431: camera, 432: plate, 433: light

## Claims

1. A substrate separation apparatus, comprising:
a holding part configured to hold both surfaces of a bonded substrate formed by bonding a pair of substrates together;
a rotational drive part configured to rotate the holding part;
a nozzle configured to separate the bonded substrate by injecting a fluid toward an outer periphery of the bonded substrate under rotation;
a nozzle movement part configured to move the nozzle;
an imaging part configured to capture an image of an outer circumferential surface of the bonded substrate held by the holding part; and
a control device configured to control the nozzle movement part,
wherein the control device is configured to control the nozzle movement part to align a position of the nozzle with a position of a separation surface of the bonded substrate detected from the image captured by the imaging part.

2. The substrate separation apparatus of Claim 1, wherein the imaging part is configured to capture images of the outer circumferential surface of the bonded substrate, which is held and rotated by the holding part, for one or more revolutions, and
wherein the control device is configured to store a rotation angle of the bonded substrate and the position of the separation surface of the bonded substrate detected from the images captured by the imaging part in association with each other, and is configured to control the nozzle movement part to align a height position of the nozzle with the position of the separation surface.

3. The substrate separation apparatus of Claim 1, wherein the imaging part is configured to capture an image of the fluid injected from the nozzle, and
wherein the control device is configured to detect an inclination of the fluid injected from the nozzle based on the image captured by the imaging part, and is configured to control the nozzle movement part to align a height position of the nozzle with a height of the separation surface based on the detected inclination of the fluid and a distance from an injection port of the nozzle to the separation surface.

4. The substrate separation apparatus of Claim 1, further comprising:
a light irradiation part configured to irradiate the outer periphery of the bonded substrate or the fluid injected from the nozzle with illumination light in a coaxial direction with the imaging part.

5. The substrate separation apparatus of Claim 1, wherein the imaging part is configured to capture images of the outer circumferential surface of the bonded substrate after separation of the bonded substrate has started and before the separation of the bonded substrate is completed, and
wherein the control device is configured to determine a separation status from the images captured by the imaging part.

6. The substrate separation apparatus of Claim 3, wherein the imaging part is configured to capture an image of the fluid injected between the imaging part and the bonded substrate while the bonded substrate is held by the holding part,
the substrate separation apparatus further comprising a plate provided between the imaging part and the bonded substrate at a position closer to the bonded substrate than the injection port of the nozzle to prevent water droplets from adhering to the imaging part.
